Europäisches Patentamt

European Patent Office

Office européen des brevets

(19)

(11) **EP 0 591 871 B1**

(12) **EUROPEAN PATENT SPECIFICATION**

(45) Date of publication and mention
of the grant of the patent:
**12.05.1999 Bulletin 1999/19**

(51) Int Cl.6: **G01R 31/00**

(21) Application number: **93115921.4**

(22) Date of filing: **01.10.1993**

(54) **A method and apparatus for the diagnostic testing of electrical equipment of a vehicle**

Verfahren und Apparat zur Diagnose der elektrischen Anlage von Fahrzeugen

Méthode et appareil pour le diagnostique de l'équipement électrique d'un véhicule

(84) Designated Contracting States:
**CH DE ES FR GB IT LI NL SE**

(30) Priority: **05.10.1992 IT TO920805**

(43) Date of publication of application:
**13.04.1994 Bulletin 1994/15**

(73) Proprietor: **IVECO FIAT S.p.A.**
**10156 Torino (IT)**

(72) Inventors:
• **Varalda, Orlando**
**10151 Torino (IT)**

• **Magrini, Maurizio**
**25126 Brescia (IT)**

(74) Representative: **Cerbaro, Elena et al**
**STUDIO TORTA S.r.l.,**
**Via Viotti, 9**
**10121 Torino (IT)**

(56) References cited:
**WO-A-90/04188**          **DE-A- 3 808 559**

## Description

The present invention relates to a method and apparatus for the diagnostic testing of the electrical equipment of a motor vehicle, such as the batteries, starter motor, alternator and regulator.

Various procedures have been developed in motor vehicles for the diagnostic testing of the operation of the devices serving for the starting and power supply of the vehicle itself. These procedures generally necessitate the dismounting of the device to be tested and its connection to apparatus for measuring appropriate electrical quantities of the device itself. Firstly, this approach involves considerable operations for dismounting and connecting the devices and, above all, does not make it possible to obtain completely reliable results in respect of the actual serviceability of the devices in the operative condition, in view of the fact that the devices themselves are tested one at a time and it is not taken into account how the less than perfect behaviour of each component influences the other components of the electrical system.

A method for the diagnostic testing of the electrical equipment of a motor vehicle is disclosed in WO-A-9 004 188 to which the preamble of claims 1 and 21 refer.

Therefore, the object of the present invention is to devise a diagnostic method and apparatus which make it possible to verify the actual serviceability of the electrical equipment, thereby obviating the disadvantages and limitations of known systems.

Accordingly, the present invention provides a method for the diagnostic testing of the electrical equipment of a motor vehicle, comprising at least one battery, a starter motor, an alternator and a regulator, characterised by verifying the serviceability of said devices in an integrated manner, measuring characteristic parameters for each device during their operation while installed on the vehicle and comparing the measured characteristic parameters with theoretical characteristic parameters calculated on the basis of the state of serviceability of at least one of the other devices.

With a view to a better understanding of the invention, a preferred embodiment thereof will now be described below, non-restrictively by way of example, with reference to the accompanying drawings, wherein:

- Figure 1 shows a block diagram of the diagnostic apparatus connected to the devices to be tested;
- Figures 2 to 6 are flow diagrams relating to the other components of the electrical system.
- Figure 7 shows the behaviour of electric signals taken from the diagram in Figure 1;
- Figure 8 is an equivalent diagram of the circuit for measuring various parameters of the batteries, and
- Figures 9 to 14 illustrate characteristic curves relating to the devices to be tested.

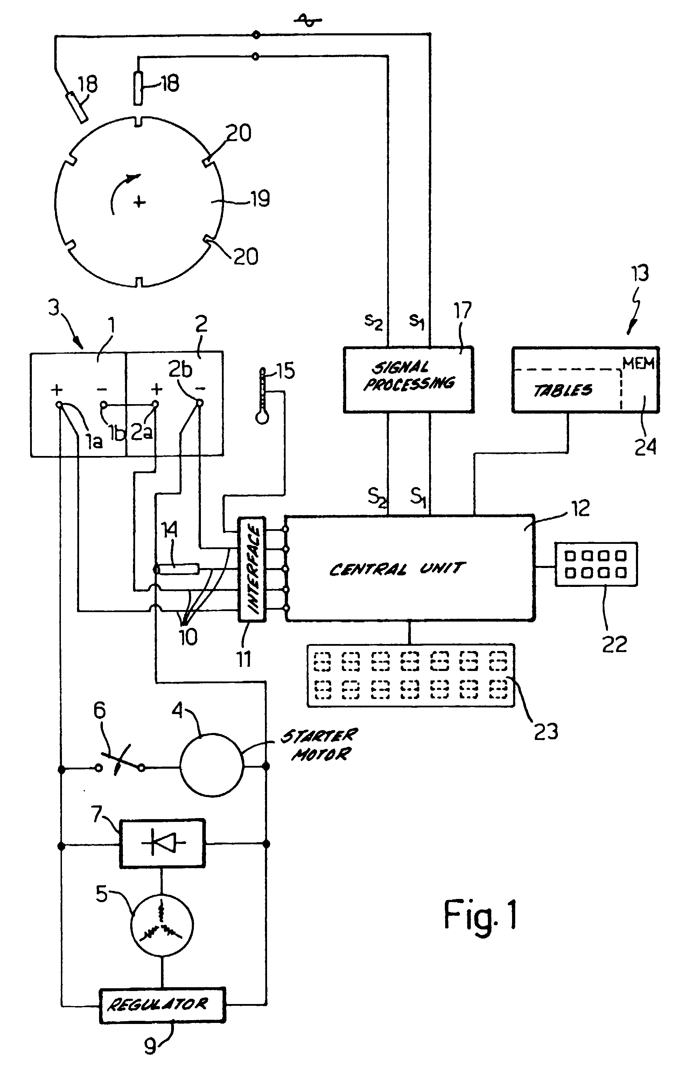

Referring now to Figure 1, the drawing shows two batteries 1 and 2 mutually connected in series and each provided with a pair of terminals 1a, 1b and 2a, 2b, respectively positive and negative. In the following description the assembly of the two batteries is frequently designated as a single battery 3 having terminals 1a and 2b. A starter motor 4, a rectifier 7 and a regulator 9 are connected in parallel with the battery 3. A switch 6 operated by the starting key of the vehicle (not shown) is provided in series with the motor 4 and an alternator (5) is connected to the rectifier 7 and the regulator 9. The regulator 9 is provided to maintain the batteries under a constant charge and it regulates the current supplied by the alternator 5 to the batteries themselves, on the basis of the voltage present between the terminals 1a and 2b.

Leads 10 connect the terminals 1a, 2a and 2b to an interface 11 which, in turn, is connected to a central unit 12 of the diagnostic apparatus according to the invention, which is generally indicated by the reference numeral 13. Additionally, the central unit 12 is connected via the interface 11 to an ammeter connection 14 serving to measure the current supplied or absorbed by the batteries.

Advantageously, to enable the ammeter connection 14 to be used for measuring both the direct current, delivered by the batteries, and the reverse current, absorbed by them (while being charged by the alternator), the "offset" voltage of the ammeter is set to a value such that the maximum value expected for the reverse current corresponds to a zero output voltage.

The central unit 12 is additionally connected, via the interface 11, to a thermometer 15 for temperature measurement and, via a signal-processing unit 17, to a pair of sensors 18 provided in the vicinity of the engine flywheel 19. The sensors 18, which are preferably of the inductive type and are spaced apart from one another at a predetermined angle of 12-24° for example, detect the passing of notches 20 provided accordingly on the periphery of the flywheel 19 and spaced apart at a predetermined angle, for example 60°.

The central unit 12 is also connected to input/output units, typically a keyboard 22 and a display unit 23, as well as a memory, including tables relating to the typical parameters and characteristics of the different electric devices to be tested.

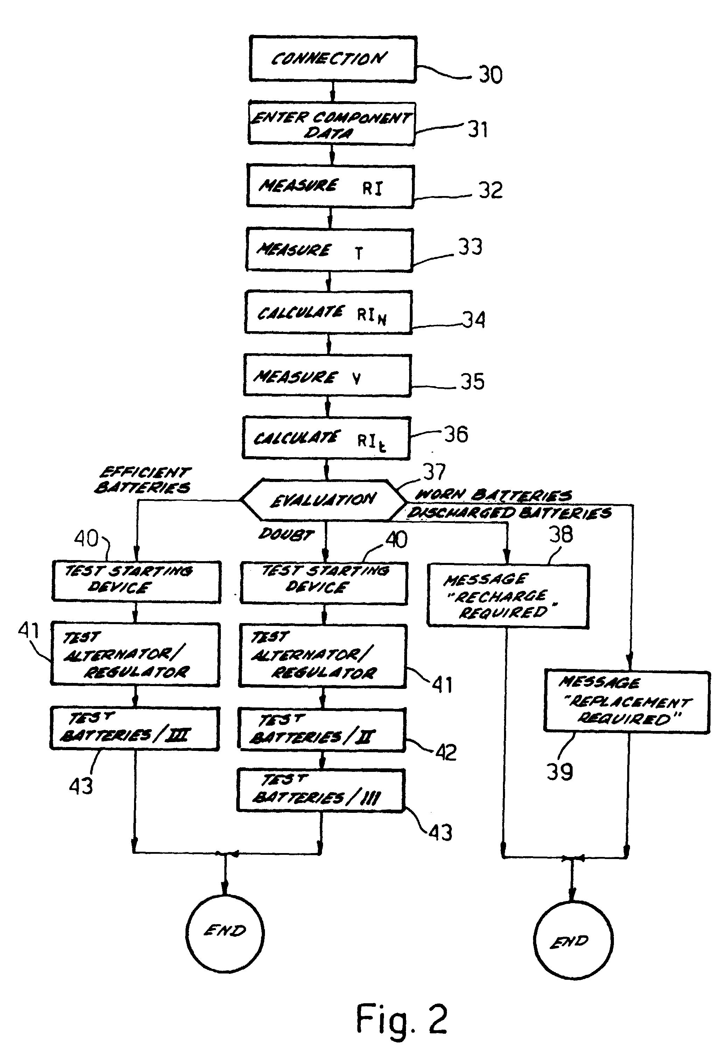

The diagnostic method according to the invention will now be described with reference to Figures 2-6. The purpose of this diagnosis is to test the starter motor, alternator, voltage regulator and batteries in an integrated manner, i.e. under conditions which entirely correspond to those of actual operation, adapting the respective characteristics to the operating conditions of the other components so as to indicate any anomalous conditions which prevent the correct operation of the various devices under the actual running conditions of vehicle. Furthermore, the investigation also has the aim of indicating the minimum temperature below which it is not certain that the vehicle will start.

The initial stage comprises verifying the state of charge and wear of the battery, which can be carried out in any known manner. Suitably, it is possible to utilise the procedure described in Italian patent application TO 91 A 000 827, filed on 31.10.1991, in the Applicant's name and which will be briefly described below for reference purposes.

Referring now to Figure 2, starting from block 30, the diagnostic apparatus 13 is connected to the battery 3 in the manner shown in the diagram of Figure 1. (In this stage, the testing of the batteries 1 and 2 can be carried out jointly, by evaluating all the characteristics of the assembly of the two batteries, as described, or the investigation can be carried out on each battery 1, 2, by measuring the characteristics of each battery separately so as to indicate the state of charge and wear of each of them). Accordingly, using the keyboard 22, the operator enters the data (for example the initials) relating to the electrical components which are to be tested, block 31, and, with the engine switched off, the system measures the actual internal resistance RI of the battery 3 (sum of the resistance values of the batteries 1 and 2), block 32. Said measurement can be carried out using any known procedure and, therefore, it will not be described. The temperature T of the battery is then measured, block 33, and the internal resistance just measured is standardised at the temperature of 25°C on the basis of the equation:

$$RI_N = RI / [1-K(T-25)], \qquad (1)$$

in which K=0.002531 (°C$^{-1}$), block 34. Subsequently, the no-load voltage V of the battery 3, which is a function of the state of charge, block 35, and the theoretical internal resistance $RI_t$ is calculated, block 36, which corresponds to the state of charge detected. For this purpose, the following algorithm is accordingly utilised, valid experimentally:

$$RI_t = K_1 + K_2 * V$$

in which $K_1 + K_2$ are parameters dependent on the batteries under consideration and are stored in the memory 24.

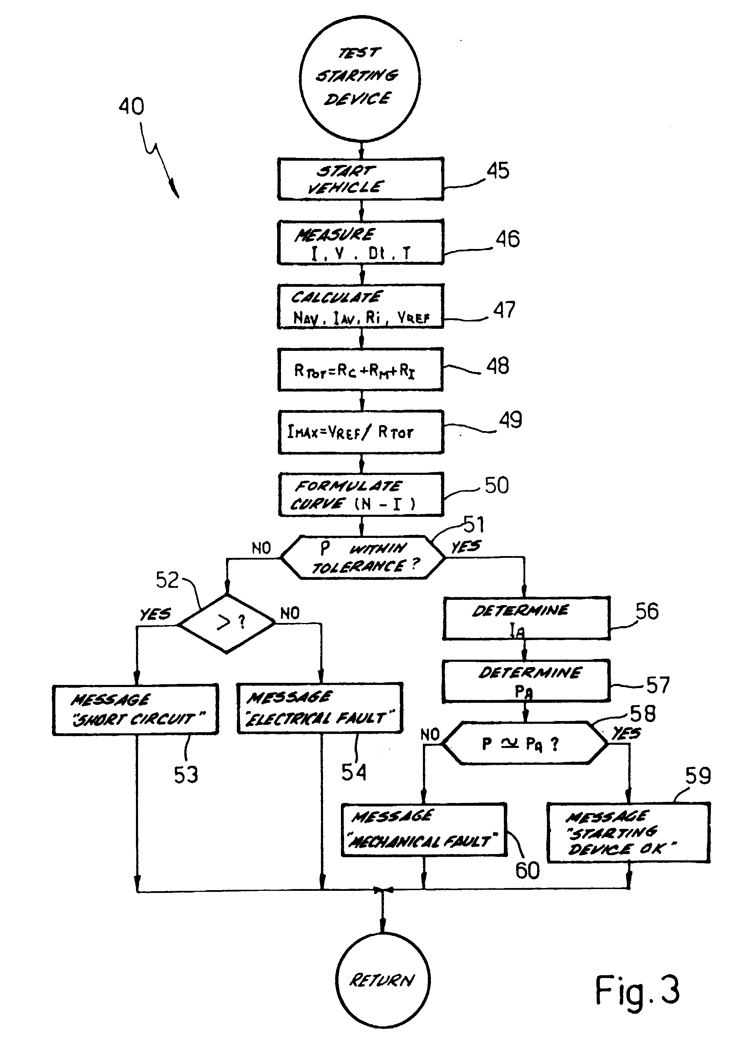

Subsequently, on the basis of the deviation present between the actual internal resistance and the standardised theoretical internal resistance, and on the basis of the value of the no-load voltage V (depending, as already stated, on the state of charge) it is possible to establish whether or not the battery is serviceable or whether superficial charges are present which do not allow the condition of the battery to be reliably determined, block 37. If it is established that the batteries are worn, a message is displayed indicating that replacement of the batteries is required (block 39) and the test ends; however, it is established that the batteries are discharged, the appropriate message is displayed (block 38) and the test ends. If any doubt exists or in the case of a positive result of the preceding test, the system proceeds with the subsequent test stages, as described in detail in Figures 3-6.

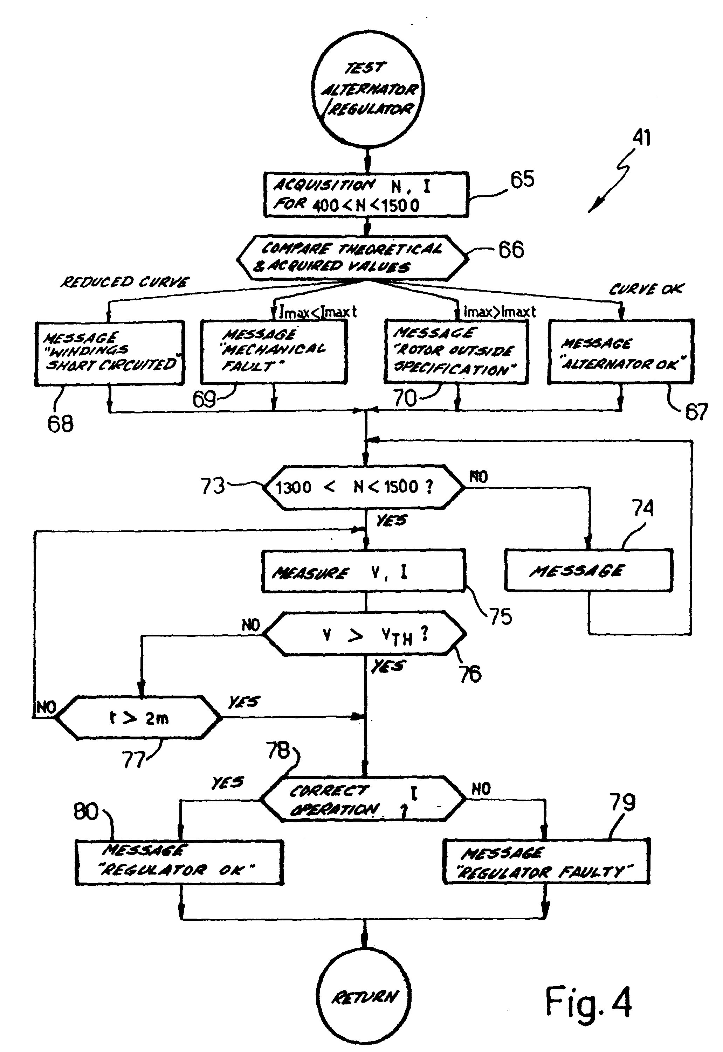

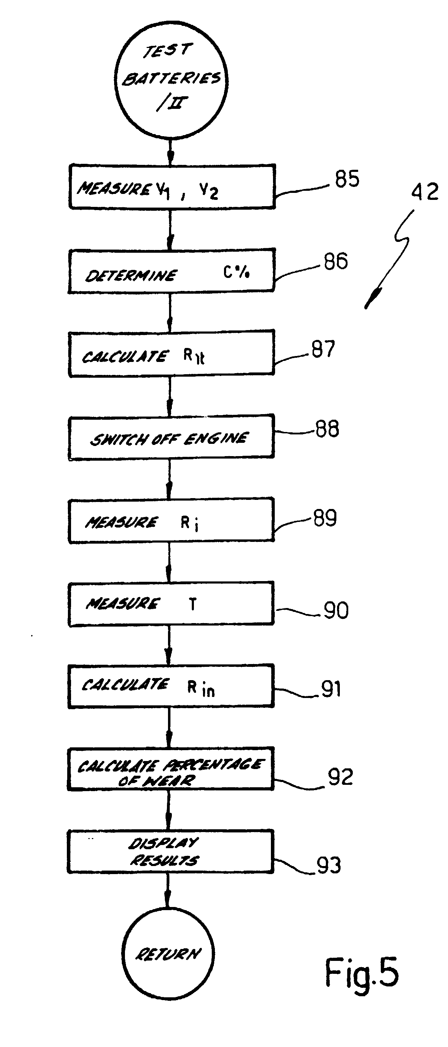

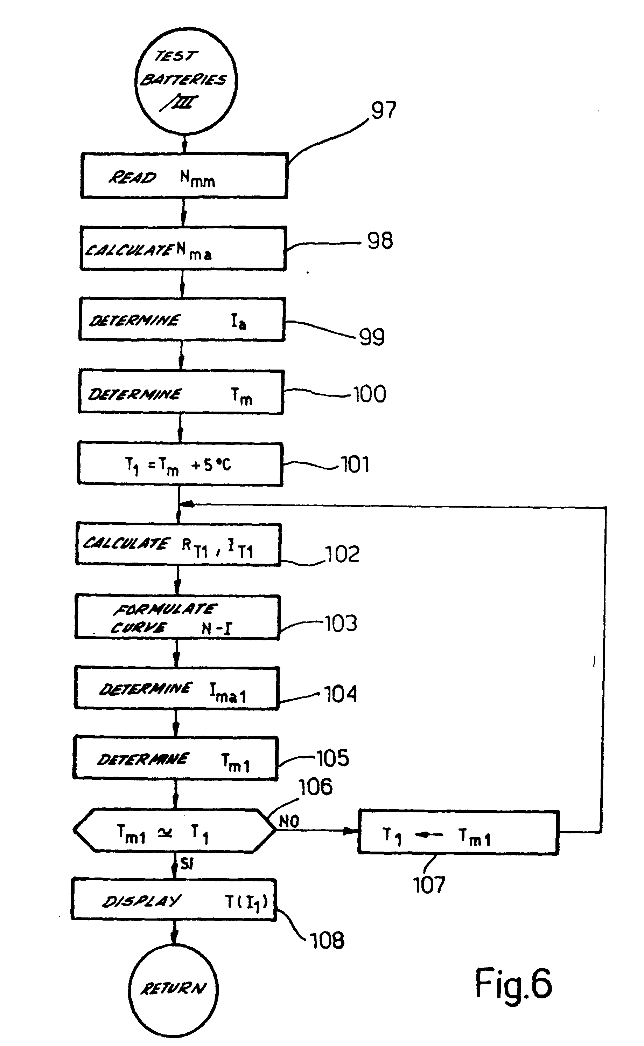

In particular, if the result of the preceding test is uncertain owing to the presence of superficial charges, there are carried out in succession: the test on the starter motor (block 40) described in detail in Figure 3, the test on the alternator and on the regulator (block 41) described in detail in Figure 4, the second part of the test on the batteries (block 42) described in detail in Figure 5, and the third part of the test on the batteries (block 43) described in detail in Figure 6. However, if the preceding test on the batteries provided positive results, there are carried out in succession: the test on the starter motor (block 40), the test on the alternator and on the regulator (block 41) and the third part of the test on the batteries (block 43), after which the procedure ends.

The starter motor test procedure will now be described. This procedure, which is carried out while the vehicle is being started, is based on a comparison between the characteristics measured and those which said motor should have depending on the general state of the batteries, since the characteristic of the starter motor depends on the condition in respect of charge and wear of the batteries supplying power to it. Therefore, according to the invention, the characteristic of said motor is formulated as a function of the maximum current which can be delivered by the batteries, as derived from the internal resistance of the batteries (including the resistance of the motor itself and the wiring). In this stage, the voltage taken as a reference for calculating the maximum current delivered cannot be that measured at the battery terminals, in that it is affected by the superficial charges, and it has to be calculated analytically, as will be described below with reference to Figure 3.

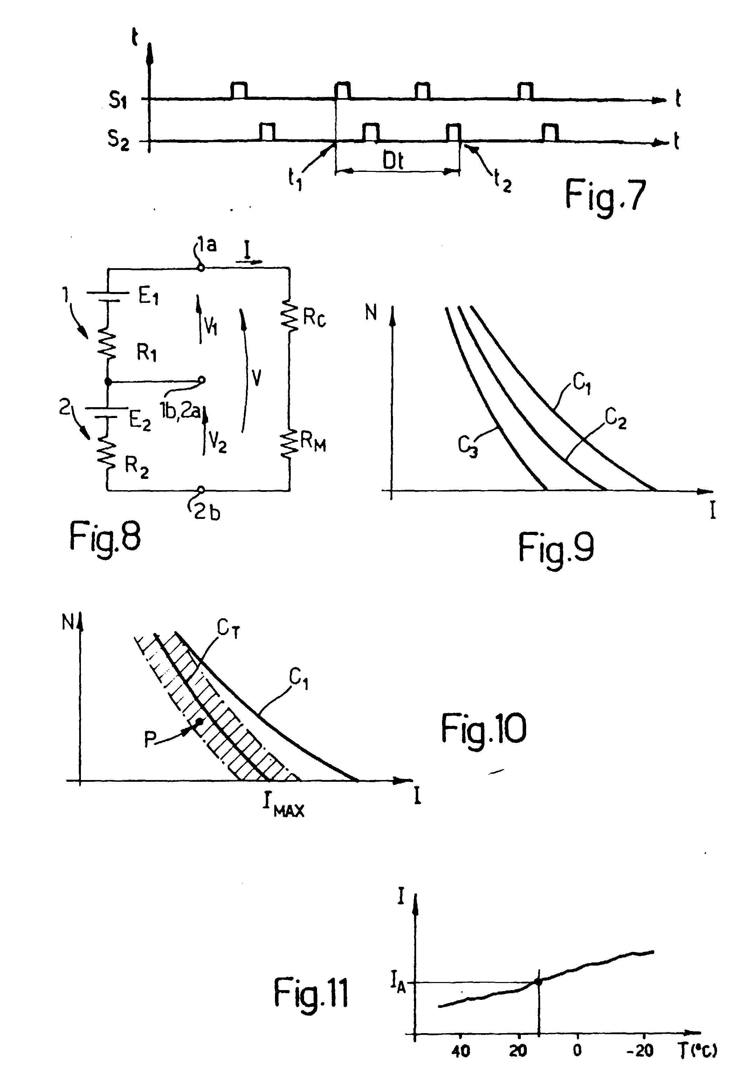

In detail, firstly a message is generated for the operator to start the vehicle (block 45). Subsequently, block 46, there are acquired the values of the voltage present between the battery terminals 1a and 2b and of the current delivered by the batteries themselves, as well as the temperature T and the time Dt elapsed between two pulses originating from the sensors 18. In fact, as indicated, upon detecting the passing of a notch 20 on the flywheel 19, each sensor generates a substantially sinusoidal pulse. The train of sinusoidal pulses, forming the signals $s_1$ and $s_2$, is fed to the circuit 17 which generates the digital signals $S_1$, $S_2$ shown in Figure 7. From each digital signal $S_1$, $S_2$ the first pulse detected at the start of flywheel rotation is rejected (since it is disturbed to a greater extent) and the current and voltage values are stored which are measured at the battery in the time interval between the second pulse of the signal $S_1$ (with leading edge at the instant $t_1$) and the third pulse of the $S_2$, with trailing edge at the instant $t_2$). The time interval Dt between the two pulses under consideration is also measured, which corresponds to the time required by the flywheel to rotate through a given angle.

Subsequently, block 47, the average number of revolutions $N_{AV}$ of the starter motor and the average current $I_{AV}$ in the interval in question are calculated, as is the internal resistance $R_i$ of the battery and the reference voltage $V_{REF}$. In particular, the number of revolutions $N_{AV}$ is calculated by determining the number average number of revolutions in the interval Dt and then said average value is multiplied by the mechanical ratio between the starter motor pinion and the flywheel. However, $R_i$ and $V_{REF}$ are calculated using the equivalent circuit shown in Figure 8, in which the batteries 1, 2 are each represented by a voltage generator $E_1$, $E_2$ and by a resistor $R_1$, R; the resistor $R_c$ represents the resistance of the wiring system (cables) and $R_M$ represents the resistance of the starter motor.

In this circuit the voltage V between the terminals 1a and 2b is given by:

$$V = E_1 + E_2 - (R_1 + R_2) * I,$$

where I is the current delivered by the batteries. By defining

$$R_i = R_1 + R_2 \text{ and } V_{REF} = E_1 + E_2,$$

there is given:

$$V = V_{REF} - R_i * I.$$

By designating V', I', and V'', I'' the current and the voltage of the batteries detected at the instants $t_1$ and $t_2$, there is given:

$$V' = V_{REF} - R_i * I'$$

$$V'' = V_{REF} - R_i * I'';$$

from which, by simple calculation,

$$R_i = (V' - V'') / (I'' - I')$$

$$V_{REF} = (I'V'' - I''V') / (I' - I'').$$

Successively, block 48, the total resistance $R_{TOT}$ of the circuit in Figure 8 is calculated,

$$R_{TOT} = R_i + R_c + R_M,$$

in which $R_M$ and $R_c$ are known from experimental measurements under stalling conditions and are compensated for in temperature).

Subsequently, the maximum current available $I_{MAX} = V_{REF}/R_{TOT}$ is calculated, block 49, and the theoretical characteristic of the starter motor in question is formulated on the basis of the condition of the batteries, block 50.

In fact, for each starter motor there is a family of curves each representing the relationship between the absorbed current and the number of revolutions for a different condition of the batteries supplying power to said motor, as shown in Figure 9, which represents three curves relating to the same motor; in particular, the curve $C_1$ is that corresponding to the connection to a battery in optimum condition, whereas the curves $C_2$ and $C_3$ are the characteristics relating to batteries in a less than optimum condition. In these curves, the maximum current absorbed corresponds to a condition at zero revolutions (stalling current) and therefore, knowing the maximum current $I_{MAX}$ which can be delivered by the battery, it is possible to determine which one of the characteristics is applicable in the case being tested.

However, the procedure just described necessitates the storing of a high number of curves and, therefore, in initial approximation, with a view to reducing the number of curves stored in the system, it is possible, for example, to derive the applicable curve in the case being tested by shifting the curve corresponding to the theoretical operation of the motor, with batteries in optimum condition (curve $C_1$ in Figure 9), until encountering the x-axis at the point $I_{MAX}$ just determined, the point at the infinity of said curve, placed on the y-axis, being maintained fixed. This procedure is shown in Figure 10, in which are plotted the curve $C_1$ under theoretical operation and the shifted curve $C_T$ obtained in the manner described. Therefore, this solution makes it possible to store only one characteristic for each type of starter motor and to derive the curve in each case formulated on the basis of the condition of the batteries, with a substantial memory saving.

Subsequently, block 51, it is evaluated whether the operating point P, which has as co-ordinates the previously calculated values in respect of current and number of revolutions $I_{AV}$, $N_{AV}$, is situated in the vicinity of the shifted curve $C_T$ and specifically within a predetermined tolerance, as indicated schematically in Figure 10 by the hatched zone delimited by the curves in chain line defining the tolerance limits. If the point P is situated below the tolerance range, output NO from the block 52, it means that there are electrical problems caused, for example, by wear in the brushes, in which case the system generates an appropriate message (block 53) and terminates this test stage. If the point P is situated above the tolerance range, output YES from the block 52, it means that a short-circuit has occurred between the windings, in which case the system generates a corresponding message (block 54) and terminates this diagnostic stage.

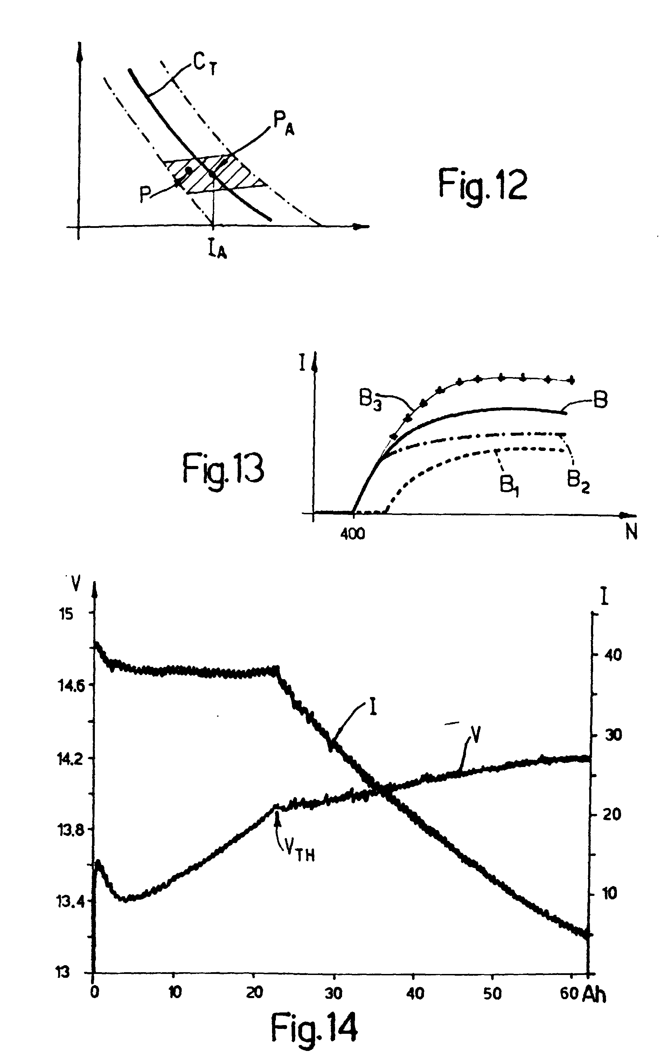

However, if the point P is situated within the tolerance range, as in the example shown in Figure 10, it is still necessary to verify whether the relationship between the number of revolutions and current corresponds approximately to that expected. For this purpose, as indicated by block 56, the current $I_A$ is determined which the motor should absorb, under correct conditions, at the temperature prevailing during the test. Said value is read from an experimental graph illustrated in Figure 11 and representing the relationship between the absorbed current and the temperature for a given motor and a given pair of batteries. Said graph is stored in tabular form in the memory 22. On the basis of the value $I_A$ there is determined, on the formulated or shifted curve $C_T$ obtained previously, the expected operating point $P_A$, as shown in Figure 12, block 57. Subsequently, the previously determined actual operating point P is compared with the expected point $P_A$, block 58. If P is situated in the vicinity of $P_A$, this means that the starter motor is in perfect operating condition, then the system generates a corresponding message, block 59, and ends this diagnostic stage. Otherwise, a problem of mechanical origin has arisen, for example caused by worn bushings or the disengagement of the coupling gears between the starter motor pinion and the flywheel. In this case a suitable message is generated for the operator, block 60, and this diagnostic stage ends.

With reference to Figure 4, the analysis of the alternator is based on a comparison between the characteristic applicable to an alternator in perfect operating condition and the curve which can be obtained from measurements taken from the alternator being tested. For this purpose, block 65, the system provides for the acquisition of the values for the current fed to the batteries when the number of revolutions N of the engine flywheel, detected by way of the sensors 18, is within the range 400-1500 rpm, i.e. before the regulator intervenes, thus limiting the current delivered by the alternator. Specifically, the system provides for the detection of the pairs of values, number of revolutions/current delivered, for the purpose of determining the curve described by the relationship present between these two quantities for the alternator being tested. The curve just obtained is then compared with the characteristic curve, as illustrated in Figure 13. In this Figure, the curve B in solid line represents the ideal characteristic for the model of alternator in question, and the curves $B_1$-$B_3$ represent curves plotted on the basis of measurements in three different cases of alternator malfunction. The comparison between the characteristic curve B and that actually measured, block 66, may give the following results: substantial coincidence between the two curves (with a tolerance of 10%, for example); measured curve having lower values with respect to the theoretical curve but similar behaviour; measured curve which initially follows the theoretical curve but then deviates therefrom (lower value for the maximum current which can be delivered);

measured curve having maximum current delivered higher than that of the theoretical curve.

The first case (substantial coincidence) indicates satisfactory alternator operation; the second case (measured curve reduced but with similar behaviour, as shown by the curve $B_1$ in Figure 13) indicates the presence of a short-circuit between the alternator windings; the third case (initially correct curve but the maximum current which can be delivered of a lower value than the theoretical value, as by the curve $B_2$) is indicative of a mechanical problem, for example that the belt is slipping; the fourth case (measured curve higher than the theoretical curve, curve $B_3$) is caused by the fitting of a rotor not conforming to specification. In all cases, the system generates a message corresponding to the situation detected (blocks 67-70) and proceeds with the testing of the regulator.

To analyse the regulator, it is simply verified that it intervenes correctly so as to limit the current delivered to the batteries by the alternator when the voltage obtained at the batteries exceeds a predetermined threshold, in accordance with the characteristic indicated in Figure 14. In this Figure there is indicated the behaviour of these two quantities as a function of the state of charge of the batteries; in known manner, when the voltage V reaches a threshold $V_{TH}$, the current absorbed by the batteries decreases as a result of the intervention of the regulator.

For this purpose, block 73, the system verifies that the vehicle is maintained at a suitable operating condition for testing (typically between 1300 and 1500 rpm), if this is not so it sends an appropriate message to the operator (block 74), otherwise (or after attaining the specified operating condition) it detects the voltage and current values of the batteries, block 75. It then verifies whether the voltage exceeds the predetermined threshold value, block 76. If this is not so, the system verifies whether two minutes have passed from the start of monitoring, block 77, and if not it returns to the measuring block 75. If the voltage exceeds the threshold value (output YES from block 76) or if the time provided for the analysis of the regulator (output YES from block 77) has elapsed, evaluation of the last current value I acquired then proceeds. In particular, this stage, which is indicated by block 78, comprises verifying that this last current value corresponds to the maximum value of the current delivered by the alternator, in the event of the voltage not having exceeded its threshold value, or verifying that the last current value acquired is lower than the maximum value (current value in respect of how much the voltage measured was below the threshold). If this comparison has a negative result, a message is generated indicating that the regulator is faulty (block 79), otherwise a correct operation message is generated (block 80) and the regulator test procedure thus ends.

Figure 5 illustrates the second part of the battery test which is carried out only if the first part has provided a doubtful result owing to the presence of superficial charges. To a large extent, the second reproduces the stages provided in the first part of the test (blocks 32-37 in Figure 2), except for the fact that the voltage measurement for determining the state of charge is carried out with the engine running so as to eliminate superficial charges.

In detail, this stage initially comprises measuring the voltages $V_1$ and $V_2$ at the terminals of the two batteries 1, 2, after the engine has been maintained at a speed of $N \geq 1500$ rpm, block 85. Subsequently, block 86, the state of charge C% of the batteries is measured, as a function of the voltage previously measured. For this purpose use is made of the voltage behaviour as a function of the percentage of charge, indicated in Figure 14 and suitably tabulated and stored in the memory 22 of the apparatus.

Successively, block 87, the theoretical internal resistance $R_{it}$ of the batteries corresponding to the state of charge just determined is calculated, in accordance with the experimental relationship:

$$R_{it} = K_1 + K_2 * C\%$$

in which $K_1 + K_2$ are parameters which depend on the batteries used (as described in greater detail in Italian patent TO91A000827, on the basis of equations (1) and (2) therein).

Subsequently, a message to switch off the engine is generated and the actual switching-off is awaited, block 88, and then the actual internal resistance $R_i$ of the batteries is measured, block 89, in an analogous manner to that described for block 32. The temperature T of the batteries is then measured, block 90, and the internal resistance just measured is standardised at the temperature of 25°C on the basis of equation (1):

$$R_{in} = R_i / [1-K(T-25)],$$

block 91. Subsequently, block 92, the percentage deviation is calculated between the theoretical internal resistance and the measured and standardised resistance, equal to

$$S\% = (R_{in} - R_{it})/ R_{it} * 100$$

as described in detail in the above-mentioned Italian patent. This percentage value provides an indication of battery wear and can thus be used for the evaluation of the state of the batteries. In particular, if the deviation thus calculated is greater than a certain threshold value, it is deduced that the batteries are worn and should be replaced. The second part of the battery test thus ends with the display of the state of wear just determined and of the state of charge previously determined, block 93.

The third part of the battery test comprises determining the minimum ambient temperature limit below which it is no longer certain that the vehicle will start. This information is useful, for example, in assessing whether, in their present state, the batteries will last the winter or whether it will be possible to undertake a journey in regions having a more severe climate, or whether it is necessary to replace the batteries.

This procedure is based on a comparison between the power supplied by the starter motor which is proportional to the current absorbed - namely to the torque - and to the number of revolutions, wherein the absorbed current has been already determined previously on the basis of the shifted curve) and the power required by the engine to enable it to be started at a given temperature. In particular, to calculate the power required, the current corresponding to the minimum number of revolutions required to guarantee that it will be possible to start the engine is determined. In turn, the minimum number of revolutions to ensure starting is derived from tables obtained experimentally for each engine type, taking into account the type of oil used and the possible presence of auxiliary equipment (for example, a thermal starter).

For this purpose, cf. Figure 6, initially the minimum number of engine revolutions $N_{mm}$ is read from a table, on the basis of data initially entered by the operator and relating to the type of engine in question, block 97. Therefore, by multiplying said value $N_{mm}$ by the mechanical ratio between the pinion and the flywheel there is obtained the minimum number of revolutions $N_{ma}$ of the motor for starting, block 98, and successively, block 99, there is calculated the value of the current $I_a$ absorbed by the motor itself in relation to the number of revolutions $N_{ma}$, using the previously determined shifted curve, as described with reference to Figure 10 (block 50 in Figure 3). The minimum temperature value $T_m$ is then obtained from the current value $I_a$ using the graph shown in Figure 11, block 100. This value does not yet represent the minimum temperature at which starting is assured, since it is calculated using a characteristic which does not take into consideration the variation in electrical characteristics of the batteries at the low temperature just determined. The temperature value just determined is then used to recalculate the power which can be delivered by the motor; however, to reduce the number of iterations required, it is increased by several degrees, for example 5°C (as indicated in block 101).

Successively, block 102, based on the new temperature value $T_1$, the internal resistance $R_{T1}$ exhibited by the batteries at the temperature $T_1$ in question is calculated, using the equation (1). From this there is calculated, in the manner already described with reference to blocks 48, 49, the total resistance of the test circuit of Figure 8 at the temperature $T_1$ and the maximum current $I_{T1}$ which can-be delivered under the same conditions. Successively, block 103, on the basis of said current value, the characteristic linking the current absorbed to the number of revolutions of the starter motor is shifted so that the new curve encounters the x-axis in relation to the current value $I_{Ti}$ just determined. From the new curve there is determined the current value $I_{mal}$ corresponding to the minimum number of revolutions $N_{ma}$ to ensure starting previously read from the table, block 104, and the associated minimum temperature $T_{m1}$ is read with reference to the graph in Figure 11, block 105.

Said temperature value $T_{m1}$ is compared with $T_1$ (block 106) and, if the two values substantially differ, the iteration is repeated, the internal resistance corresponding to the new temperature value being recalculated (blocks 107, 102).

However, if the two values are sufficiently similar the temperature value just determined is displayed, block 108, and represents the the minimum temperature at which the starting of the vehicle is assured with the batteries undergoing testing.

The method and apparatus described thus make possible reliable evaluation of the serviceability of the electrical ignition and power supply devices of a motor vehicle, under conditions which are equivalent to operating conditions, also taking the interactions of the devices themselves into account.

Moreover, the performance of the tests provided does not require the operator to carry out any complicated or protracted operations. In fact, it is only necessary for the operator to connect the apparatus to the batteries and rotation sensors already provided, start the engine and maintain it at the operating speed specified in each case. Furthermore, the control and switching off of the engine may also be carried out automatically, if the vehicle is equipped with electronic control, by way of commands issued by the test apparatus itself.

Finally, the apparatus described makes it possible to obtain a large amount of data regarding the operation of the electrical equipment, including the minimum temperature at which starting is possible.

Lastly, it is evident that modifications and variations can be made to the method and apparatus described and illustrated, without thereby departing from the scope of protection of the present invention. In particular, it is emphasized that the measurement of the actual internal resistance and the calculation of the nominal internal resistance of the batteries can be carried out in accordance with any known method; moreover, the entire stage of evaluating the state of charge and wear of the batteries can be carried out in a different manner to that described, it being a constant factor that the results obtained are used to evaluate the serviceability of the other electrical devices depending on the state of the batteries themselves.

## Claims

1. A method for the diagnostic testing of the electrical equipment of a motor vehicle, comprising at least one battery (3), a starter motor (4), an alternator (5) and a regulator (9), characterised by verifying the serviceability of said at least one battery (3), said starter motor (4), said alternator (5) and said regulator (9) in an integrated manner, measuring characteristic parameters for each device among said at least one battery (3), said starter motor (4), said alternator (5) and said regulator (9) during their operation while installed on the vehicle and comparing the measured characteristic parameters with theoretical characteristic parameters calculated on the basis of the state of serviceability of at least one other device among said at least one battery (3), said starter motor (4), said alternator (5) and said regulator (9).

2. A method according to Claim 1, characterised by the steps of: determining (50) a characteristic curve correlating the number of revolutions and the current absorbed by said starter motor when connected operatively to said battery, determining (47) the operating point of said motor immediately after starting the vehicle and verifying (51) whether said operating point determined is situated in the vicinity of said characteristic curve.

3. A method according to Claim 2, characterised by a preliminary step (46-50) of evaluating the state of the battery and formulatingthe characteristic curve relating to said starter motor on the basis of said state of the battery.

4. A method according to Claim 3, characterised in that said preliminary evaluating and formulating step comprises determining (46-49) the maximum current be delivered by said battery under stalling conditions, and determining (50) the characteristic relation between, number of revolutions and the corresponding current, of said motor having stalling current equal to said maximum current determined.

5. A method according to Claim 4, characterised in that said step of determining (50) the characteristic comprises shifting a theoretical characteristic for said motor with said battery in optimum condition until it encounters said maximum current determined.

6. A method according to Claim 4 or 5, characterised in that said step of determining the maximum current which can be delivered comprises the steps of measuring (46) the voltage present at the battery terminals and the current delivered by said battery in two successive instants immediately after the starting of the vehicle, calculating (47) the internal resistance and reference voltage of said battery on the basis of said measured current and voltage values, calculating (48) the total resistance including said battery and determining (49) the maximum current delivered as a ratio between said reference voltage and said total resistance.

7. A method according to any one of Claims 2 to 5, characterised in that said step of determining the operating point of said motor comprises the step of measuring (47) the average number of revolutions of said motor and the average current absorbed by said motor immediately after starting said vehicle.

8. A method according to Claim 6 or 7, characterised by detecting pulses ($s_1$, $s_2$) generated by at least one rotation sensor (18) mounted on a flywheel (19) of the vehicle, rejecting the first pulse after starting the vehicle and measuring said average number of revolutions and said average current in a time interval between the second and third pulse of said sensor.

9. A method according to any one of Claims 2 to 8, characterised by the steps of determining (46, 56, 57) an expected operating point for said motor and comparing (58) said expected operating point and said determined operating point.

10. A method according to Claim 9, characterised in that said step of determining an expected operating point comprises the steps of measuring (46) the temperature of the battery, determining (56) a value for the expected absorbed current on the basis of an experimental temperature-current relationship, determining (57) a value for the expected number of revolutions on said characteristic corresponding to said expected current value.

11. A method according to any one of Claims 1 to 10, characterised by the step of detecting (65) a characteristic curve of said alternator (5) while said battery (3) is being charged.

12. A method according to Claim 11, characterised in that said step of detecting comprises the continuous acquisition (65) of a signal representing the number of revolutions and the current delivered by said alternator after starting the vehicle within a predetermined range of the number of revolutions of said alternator, and by a step of comparing (66) said detected characteristic curve with a nominal curve.

13. A method according to any one of Claims 1 to 12, characterised by the step of determining (75-77) the behaviour of the current absorbed by said battery (3) and the voltage at said battery within a predetermined range of the number of revolutions of an engine flywheel (19) of the vehicle.

14. A method according to Claim 13, characterised in that said step of determining the behaviour comprises the steps of measuring (75) the voltage at said battery and the current absorbed by said battery when the number of revolutions is above a predetermined limit, and comparing (76) said measured voltage with a threshold value; and also comprising the step of comparing (78) two values for measured current respectively before and after said voltage has exceeded said threshold value.

15. A method according to any one of Claims 1 to 14, characterised by the step of determining (97-108) the minimum temperature at which it is possible to start the vehicle on the basis of the battery condition (39).

16. A method according to Claim 15, characterised in that said temperature-determining stage comprises the steps of: determining (102-103) the power generated by said starter motor (4) and said battery (3), determining the power (97-99, 104) required for starting an engine of the vehicle at a given temperature and effecting a comparison between said power generated and said power required.

17. A method according to Claim 16, characterised by the steps of: determining (97) the nominal minimum number of revolutions for starting said engine on the basis of experimental values, determining (99) the nominal current absorbed by said motor (4) on the basis of said number of nominal minimum number of revolutions, determining (100) a first minimum temperature value corresponding to the nominal absorbed current, determining (102) an internal resistance value of said battery on the basis of said first temperature value, determining (102) a value for the maximum current which can be delivered by said battery on the basis of said internal resistance, determining (103, 104) a new value for the current absorbed by said motor on the basis of said value for the maximum current which can be delivered, determining (105) a new minimum temperature value corresponding to said absorbed current value.

18. A method according to Claim 17, characterised by repeating the steps of determining (102-107) values in respect of internal resistance, maximum current delivered, current absorbed and minimum temperature on the basis of said new temperature value until attaining (106) two equal temperature values, within tolerance limits, in successive iterations.

19. A method according to Claim 17 or 18, characterised in that, before carrying out said step of determining (102) an internal resistance value of said battery (3) on the basis of said first temperature value, said first temperature value is increased (101) by a predetermined value.

20. A method according to any one of Claims 17 to 19, characterised in that said step of determining (99) the nominal current absorbed by said motor is carried out on the basis of a characteristic curve of said motor (4) in the condition connected to said battery (3); in that said steps of determining (100, 105) a minimum temperature value are carried out on the basis of an experimentally determined plot, and said steps of determining (104) a new value for the current absorbed is carried out on a characteristic curve (103) formulated on the basis of said value for the maximum current which can be delivered.

21. An apparatus for carrying out the method for the diagnostic testing of the electrical equipment of a motor vehicle, comprising at least one battery (3), a starter motor (4), an alternator (5) and a regulator (9), according to any one of Claims 1-20, characterised by comprising means (12) adapted to verify the serviceability of said at least one battery (3), said starter motor (4), said alternator (5) and said regulator (9) in an integrated manner, including means adapted to measure characteristic parameters for each device among said at least one battery (3), said starter motor (4), said alternator (5) and said regulator (9) during their operation while installed on the vehicle and to compare the characteristic parameters measured with theoretical characteristic parameters calculated on the basis of the state of serviceability of at least one other device among said at least one battery (3), said starter motor (4), said alternator (5) and said regulator (9).

22. An apparatus according to Claim 21, characterised by comprising means (12, 15) for measuring the voltage, the current and the temperature of the battery, means (18) for detecting the number of engine revolutions and means (12) adapted to correlate the current and voltage values measured with the number of revolutions and the temperature detected, and to determine actual operating characteristics.

**Patentansprüche**

1. Verfahren für das Diagnosetesten der elektrischen Anlage eines Motorfahrzeugs mit mindestens einer Batterie (3), einem Anlassermotor (4), einem Wechselstromgenerator (5) und einem Stellglied (9), gekennzeichnet durch das Verifizieren des Gebrauchswerts der mindestens einen Batterie (3), des Anlassermotors (4), des Wechselstromgenerators (5) und des Stellglieds (9) in integrierter Weise, das Messen der Kennparameter für jede Einrichtung von der mindestens einen Batterie (3), dem Anlassermotor (4), dem Wechselstromgenerator (5) und dem Stellglied (9) während ihres Betriebs bei Installierung in dem Fahrzeug und Vergleich der gemessenen Kennparameter mit theoretischen Kennparametern, die auf der Grundlage des Gebrauchswertszustands mindestens einer anderen Einrichtung von der mindestens einen Batterie (3), dem Anlassermotor (4), dem Wechselstromgenerator (5) und dem Stellglied (9) berechnet sind.

2. Verfahren nach Anspruch 1, gekennzeichnet durch die Schritte: Bestimmen (50) einer Kennkurve, mit der die Umdrehungszahl und der von dem Anlasser bei betriebsgemäßer Verbindung mit der Batterie absorbierte Strom korreliert sind, Bestimmen (47) des Betriebspunkts für den Motor unmittelbar nach dem Start des Fahrzeugs und Verifizieren (51) der Tatsache, ob der bestimmte Betriebspunkt in der Nähe der Kennkurve angeordnet ist.

3. Verfahren nach Anspruch 2, gekennzeichnet durch einen vorangehenden Schritt (46-50) zum Bewerten des Zustands der Batterie und zum Formulieren der Kennkurve im Zusammenhang mit dem Anlassermotor auf der Grundlage des Zustands der Batterie.

4. Verfahren nach Anspruch 3, dadurch gekennzeichnet, daß der Schritt zum vorläufigen Bewerten und Formulieren das Bestimmen (46-49) des durch die Batterie bei Abwürgebedingungen abgegebenen Maximalstroms umfaßt, sowie das Bestimmen (50) der kennzeichnenden Beziehung zwischen der Umdrehungszahl und dem zugeordneten Strom für den Motor mit dem Abwürgestrom gleich dem bestimmten Maximalstrom.

5. Verfahren nach Anspruch 4, dadurch gekennzeichnet, daß der Schritt S zum Bestimmen (50) der Kennlinie das Verschieben einer theoretischen Kennlinie für den Motor mit Batterie in optimaler Bedingung umfaßt, solange, bis sie den bestimmten Maximalstrom trifft.

6. Verfahren nach Anspruch 4 oder 5, dadurch gekennzeichnet, daß der Schritt zum Bestimmen des abgebbaren Maximalschritts die Schritte zum Messen (46) der Spannung bei den Batterieanschlüssen und des durch die Batterie abgegebenen Stroms in zwei nachfolgenden Zeitpunkten unmittelbar nach dem Start des Fahrzeugs enthält, sowie zum Berechnen (47) des Innenwiderstands und der Referenzspannung der Batterie auf der Grundlage der gemessenen Strom- und Spannungswerte, zum Berechnen (58) des Gesamtwiderstandswerts einschließlich der Batterie und zum Bestimmen (49) des abgegebenen Maximalstroms als Verhältnis zwischen der Referenzspannung und dem Gesamtwiderstandswert.

7. Verfahren nach einem der Ansprüche 2 bis 5, dadurch gekennzeichnet, daß der Schritt zum Bestimmen des Betriebspunkts des Motors den Schritt zum Messen (47) der durchschnittlichen Zahl von Umdrehungen und des von dem Motor unmittelbar nach dem Start des Fahrzeugs absorbierten Durchschnittsstroms enthält.

8. Verfahren nach Anspruch 6 oder 7, gekennzeichnet durch das Detektieren von Pulsen ($s_1$, $s_2$), die bei mindestens einem an einem Schwungrad (19) des Fahrzeugs montierten Drehsensor (18) erzeugt werden, Verwerten des ersten Pulses nach dem Start des Fahrzeugs und Messen der durchschnittlichen Umdrehungszahl und des Durchschnittsstroms in einem Zeitintervall zwischen dem zweiten und dritten Impuls des Sensors.

9. Verfahren nach einem der Ansprüche 2 bis 8, gekennzeichnet durch die Schritte zum Bestimmen (46, 56, 57) eines erwarteten Betriebspunkts für den Motor und zum Vergleichen (48) des erwarteten Betriebspunkts mit dem bestimmten Betriebspunkt.

10. Verfahren nach Anspruch 9, dadurch gekennzeichnet, daß der Schritt zum Bestimmen eines erwarteten Betriebspunkts die Schritte zum Messen (46) der Batterietemperatur enthält, sowie zum Bestimmen (56) eines Werts für den erwarteten absorbierten Strom auf der Grundlage einer experimentellen Temperatur-Strom-Beziehung, zum Bestimmen (57) eines Werts für die erwartete Umdrehungszahl bei der Kennlinie gemäß dem erwarteten Stromwert.

11. Verfahren nach einem der Ansprüche 1 bis 10, gekennzeichnet durch den Schritt zum Detektieren (65) einer Kennkurve des Wechselstromgenerators (5) bei Laden der Batterie (3).

12. Verfahren nach Anspruch 11, dadurch gekennzeichnet, daß der Schritt zum Detektieren das fortlaufende Erfassen (65) eines Signals zum Darstellen der Umdrehungszahl enthält und des durch den Wechselstromgenerator nach dem Start des Fahrzeugs innerhalb eines bestimmten Bereichs der Umdrehungszahlen des Wechselstromgenerators abgegebenen Stroms, sowie durch einen Schritt zum Vergleichen (66) der detektierten Kennkurve mit einer nominellen Kurve.

13. Verfahren nach einem der Ansprüche 1 bis 12, gekennzeichnet durch den Schritt zum Bestimmten (75-77) des Verhaltens des Stroms, der durch die Batterie (3) absorbiert wird, und der Spannung bei der Batterie in einem Bereich der Umdrehungszahl eines Motorschwungrads (19) des Fahrzeugs.

14. Verfahren nach Anspruch 13, dadurch gekennzeichnet, daß der Schritt zum Bestimmen des Verhaltens die Schritte zum Messen (75) der Spannung bei der Batterie und des durch die Batterie absorbierten Stroms mit vorliegender Umdrehungszahl oberhalb einer vorgegebenen Grenze enthält, sowie das Vergleichen (76) der gemessenen Spannung mit einem Schwellwert; und daß er ebenfalls den Schritt zum Vergleichen (78) zweier Werte für den gemessenen Strom jeweils vor und nach dem Übersteigen des Schwellwerts durch die Spannung enthält.

15. Verfahren nach einem der Ansprüche 1 bis 14, gekennzeichnet durch den Schritt zum Bestimmen (97-108) der Minimaltemperatur, mit der es möglich ist, das Fahrzeug auf Grundlage der Batteriebedingung (39) zu starten.

16. Verfahren nach Anspruch 15, dadurch gekennzeichnet, daß die Stufe zum Bestimmen der Temperatur die folgenden Schritte enthält: Bestimmen (102-103) der durch den Anlassermotor (4) und die Batterie (3) erzeugten Energie, Bestimmen der Energie (97-99, 104), die zum Starten eines Motors des Fahrzeugs bei einer gegebenen Temperatur erforderlich ist, und Bewirken eines Vergleichs zwischen der erzeugten Energie und der erforderlichen Energie.

17. Verfahren nach Anspruch 16, gekennzeichnet durch die Schritte: Bestimmen (97) der nominellen minimalen Umdrehungszahl für das Starten des Motors auf der Grundlage der experimentellen Werte, Bestimmen (99) des nominellen durch den Motor (4) absorbierten Stroms auf der Grundlage der Zahl der nominellen minimalen Umdrehungszahl, Bestimmen (100) eines ersten minimalen Temperaturwerts gemäß dem nominellen absorbierten Strom, Bestimmen (102) eines Innenwiderstandswerts der Batterie auf der Grundlage des ersten Temperaturwerts, Bestimmen (102) eines Werts für den Maximalstrom, der sich durch die Batterie abgeben läßt, auf der Grundlage des Innenwiderstandswertes, Bestimmen (103, 104) eines neuen Werts für den durch den Motor absorbierten Strom auf der Grundlage des Werts für den Maximalstrom, der sich abgeben läßt, Bestimmen (105) eines neuen minimalen Temperaturwerts gemäß dem absorbierten Stromwert.

18. Verfahren nach Anspruch 17, gekennzeichnet durch das Wiederholen der Schritte zum Bestimmen (102-107) der Werte im Hinblick auf den Innenwiderstandswert, den maximal abgegebenen Strom, den absorbierten Strom und der minimalten Temperatur auf der Grundlage des neuen Temperaturwerts, bis zwei gleiche Temperaturwerte erzielt werden (106), innerhalb der Toleranzgrenzwerte, bei sukzessiven Iterationen.

19. Verfahren nach Anspruch 17 oder 18, dadurch gekennzeichnet, daß vor dem Durchführen des Schritts zum Bestimmen (102) eines Innenwiderstandswerts der Batterie (3) auf der Grundlage des ersten Temperaturwerts der erste Temperaturwert (101) um einen vorbestimmten Wert erhöht wird.

20. Verfahren nach einem der Ansprüche 17 bis 19, dadurch gekennzeichnet, daß der Schritt zum Bestimmen (99) des nominellen durch den Motor absorbierten Stroms auf der Grundlage einer Kennlinie des Motors (4) bei einer Bedingung mit angeschlossener Batterie (3) durchgeführt wird; daß die Schritte zum Bestimmen (100, 105) eines minimalen Temperaturwerts auf der Grundlage einer experimentell bestimmten Skizze durchgeführt werden, und die Schritte zum Bestimmen (104) eines neuen Werts für den absorbierten Schritt anhand einer Kennlinie (103) durchgeführt werden, die auf der Grundlage des Werts für den maximal abgebbaren Stroms formuliert wird.

21. Gerät zum Durchführen des Verfahrens für das Diagnosetesten der elektrischen Anlage eines Motorfahrzeugs mit mindestens einer Batterie (3), einem Anlassermotor (4), einem Wechselstromgenerator (5) und einem Stellglied (9) gemäß einem der Ansprüche 1 bis 20, dadurch gekennzeichnet, daß es eine Vorrichtung (12) enthält, die zum Verifizieren des Gebrauchswerts der mindestens einen Batterie (3), des Anlassermotors (4), des Wechselstromgenerators (5) und des Stellglieds (9) in integrierter Weise angepaßt ist, einschließlich einer Vorrichtung, die zum Messen von Kennparamtetern für jede Einrichtung von der mindestens einen Batterie (3), dem Anlassermotor (4), dem Wechselstromgenerator (5) und dem Stellglied (9) angepaßt ist, bei deren Betrieb in installierter Weise in dem Fahrzeug, sowie zum Vergleichen der gemessenen Kennparameter mit theoretischen Kennparametern, die auf der Grundlage des Gebrauchswertzustands von mindestens einer anderen Einrichtung von der mindestens einen Batterie (3), dem Anlassermotor (4), dem Wechselstromgenerator (5) und dem Stellglied (9) berechnet sind.

22. Gerät nach Anspruch 21, dadurch gekennzeichnet, daß es eine Vorrichtung (12, 15) zum Messen der Spannung, des Stroms und der Temperatur der Batterie enthält, eine Vorrichtung (18) zum Detektieren der Zahl der Motorumdrehungen und eine Vorrichtung (12), die zum Korrelieren der gemessenen Strom- und Spannungswerte mit der Umdrehungszahl und der detektierten Temperatur ausgebildet ist, sowie zum Bestimmen der tatsächlichen Betriebseigenschaften.

**Revendications**

1. Procédé de contrôle pour le diagnostic de l'équipement électrique d'un véhicule automobile comprenant au moins une batterie (3), un moteur de démarreur (4), un alternateur (5) et un régulateur (9), caractérisé par la vérification du fonctionnement correct de ladite au moins une batterie (3), dudit moteur de démarreur (4), dudit alternateur (5) et dudit régulateur (9) d'une manière intégrée, la mesure de paramètres caractéristiques de chaque dispositif parmi ladite au moins une batterie (3), ledit moteur de démarreur (4), ledit alternateur (5) et ledit régulateur (9) au cours de leur fonctionnement lorsqu'ils sont installés sur le véhicule et la comparaison des paramètres caractéristiques mesurés à des paramètres caractéristiques théoriques calculés à partir de l'état de fonctionnement correct d'au moins un autre dispositif parmi ladite au moins une batterie (3), ledit moteur de démarreur (4), ledit alternateur (5) et ledit régulateur (9).

2. Procédé selon la revendication 1, caractérisé par les étapes de: détermination (50) d'une courbe caractéristique établissant la corrélation entre la vitesse de rotation et le courant absorbé par ledit moteur de démarreur lorsqu'il est connecté de manière opérationnelle à ladite batterie, détermination (47) du point de fonctionnement dudit moteur immédiatement après le démarrage du véhicule et vérification (51) de ce que ledit point de fonctionnement déterminé est situé à proximité de ladite courbe caractéristique.

3. Procédé selon la revendication 2, caractérisé par une étape préliminaire (46 à 50) d'évaluation de l'état de la batterie et d'établissement de la courbe caractéristique se rapportant audit moteur de démarreur, sur la base dudit état de la batterie.

4. Procédé selon la revendication 3, caractérisé en ce que ladite étape préliminaire d'évaluation et d'établissement comprend la détermination (46 à 49) du courant maximum délivré par ladite batterie dans des conditions de blocage, et la détermination (50) de la relation caractéristique entre la vitesse de rotation et le courant correspondant dudit moteur pour laquelle le courant de blocage est égal audit courant maximum déterminé.

5. Procédé selon la revendication 4, caractérisé en ce que ladite étape de détermination (50) de la relation caractéristique comprend le déplacement d'une caractéristique théorique dudit moteur, avec ladite batterie dans son état optimal, jusqu'à ce qu'elle rencontre ledit courant maximum déterminé.

6. Procédé selon la revendication 4 ou 5, caractérisé en ce que ladite étape de détermination du courant maximum qui peut être délivré comprend les étapes de mesure (46) de la tension présente aux bornes de la batterie et du courant délivré par ladite batterie à deux instants successifs immédiatement après le démarrage du véhicule, de calcul (47) de la résistance interne et de la tension de référence de ladite batterie à partir desdites valeurs de courant et de tension mesurées, de calcul (48) de la résistance totale, comprenant celle de ladite batterie, et de détermination (49) du courant maximum délivré sous forme d'un rapport entre ladite tension de référence et ladite résistance totale.

7. Procédé selon l'une quelconque des revendications 2 à 5, caractérisé en ce que ladite étape de détermination du point de fonctionnement dudit moteur comprend l'étape de mesure (47) de la vitesse de rotation moyenne dudit moteur et du courant moyen absorbé par ledit moteur immédiatement après le démarrage dudit véhicule.

8. Procédé selon la revendication 6 ou 7, caractérisé par la détection d'impulsions ($s_1$, $s_2$), produites par au moins un capteur de rotation (18) monté sur un volant (19) du véhicule, l'élimination de la première impulsion après démarrage du véhicule et la mesure de ladite vitesse de rotation moyenne et dudit courant moyen sur un intervalle de temps compris entre les deuxième et troisième impulsions dudit capteur.

9. Procédé selon l'une quelconque des revendications 2 à 8, caractérisé par les étapes de détermination (46, 56, 57) d'un point de fonctionnement attendu pour ledit moteur et de comparaison (58) dudit point de fonctionnement attendu et dudit point de fonctionnement déterminé.

10. Procédé selon la revendication 9, caractérisé en ce que ladite étape de détermination d'un point de fonctionnement attendu comprend les étapes de mesure (46) de la température de la batterie, de détermination (56) d'une valeur du courant absorbé attendu à partir d'une relation température-courant expérimentale, de détermination (57) d'une valeur de la vitesse de rotation attendue sur ladite caractéristique correspondant à ladite valeur de courant attendu.

11. Procédé selon l'une quelconque des revendications 1 à 10, caractérisé par l'étape de détection (65) d'une courbe caractéristique dudit alternateur (5) pendant que ladite batterie (3) est en charge.

12. Procédé selon la revendication 11, caractérisé en ce que ladite étape de détection comprend l'acquisition en continu (65) d'un signal représentant la vitesse de rotation et le courant délivré par ledit alternateur après démarrage du véhicule, dans une plage prédéterminée de vitesses de rotation dudit alternateur, et par une étape de comparaison (66) de ladite courbe caractéristique détectée à une courbe nominale.

13. Procédé selon l'une quelconque des revendications 1 à 12, caractérisé par l'étape de détermination (75 à 77) de l'évolution du courant absorbé par ladite batterie (3) et de la tension aux bornes de ladite batterie, dans une plage prédéterminée de vitesses de rotation d'un volant (19) du moteur du véhicule.

14. Procédé selon la revendication 13, caractérisé en ce que ladite étape de détermination de l'évolution comprend les étapes de mesure (75) de la tension aux bornes de ladite batterie et du courant absorbé par ladite batterie lorsque la vitesse de rotation est supérieure à une limite prédéterminée, et de comparaison (76) de ladite tension mesurée à une valeur de seuil; et comprenant aussi l'étape de comparaison (78) de deux valeurs du courant mesuré, respectivement avant et après que ladite tension a dépassé ladite valeur de seuil.

15. Procédé selon l'une quelconque des revendications 1 à 14, caractérisé par l'étape de détermination (97 à 108) de la température minimum à laquelle il est possible de démarrer le véhicule, sur la base de l'état de la batterie (39).

16. Procédé selon la revendication 15, caractérisé en ce que ladite étape de détermination de température comprend les étapes de: détermination (102 à 103) de la puissance produite par ledit moteur de démarreur (4) et ladite batterie (3), détermination de la puissance (97 à 99, 104) requise pour le démarrage d'un moteur du véhicule à une température donnée et exécution d'une comparaison entre puissance produite et ladite puissance requise.

17. Procédé selon la revendication 16, caractérisé par les étapes: détermination (97) de la vitesse de rotation minimum nominale permettant d'assurer le démarrage dudit moteur à partir de valeurs expérimentales, détermination (99) du courant nominal absorbé par ledit moteur (4) à partir de ladite vitesse de rotation minimum nominale, détermination (100) d'une première valeur de température minimale correspondant au courant nominal absorbé, détermination (102) d'une valeur de résistance interne de ladite batterie à partir de ladite première valeur de température, détermination (102) d'une valeur du courant maximum qui peut être délivré par ladite batterie à partir de ladite résistance interne, détermination (103, 104) d'une nouvelle valeur pour le courant absorbé par ledit moteur à partir de ladite valeur du courant maximum qui peut être délivré, détermination (105) d'une nouvelle valeur de température minimale correspondant à ladite valeur de courant absorbé.

18. Procédé selon la revendication 17, caractérisé par la répétition des étapes de détermination (102 à 107) de valeurs relativement à la résistance interne, au courant maximum délivré, au courant absorbé et à la température minimale, à partir de ladite nouvelle valeur de température, jusqu'à atteindre (106) deux valeurs de température identiques, dans des limites de tolérance, par itérations successives.

19. Procédé selon la revendication 17 ou 18, caractérisé en ce que, avant la réalisation de ladite étape de détermination (102) d'une valeur de résistance interne de ladite batterie (3) à partir de ladite première valeur de température, ladite première valeur de température est augmentée (101) d'une valeur prédéterminée.

20. Procédé selon l'une quelconque des revendications 17 à 19, caractérisé en ce que ladite étape de détermination (99) du courant nominal absorbé par ledit moteur est réalisée à partir d'une courbe caractéristique dudit moteur (4) dans l'état raccordé à ladite batterie (3); en ce que lesdites étapes de détermination (100, 105) d'une valeur de température minimale sont réalisées à partir d'une courbe tracée de manière expérimentale, et ladite étape de détermination (104) d'une nouvelle valeur pour le courant absorbé est réalisée sur une courbe caractéristique (103) à partir de ladite valeur du courant maximum qui peut être délivré.

21. Dispositif destiné à mettre en oeuvre le procédé de contrôle pour le diagnostic de l'équipement électrique d'un véhicule automobile comprenant au moins une batterie (3), un moteur de démarreur (4), un alternateur (5) et un régulateur (9), selon l'une quelconque des revendications 1 à 20, caractérisé par le fait qu'il comprend des moyens (12) destinés à vérifier le fonctionnement correct de ladite au moins une batterie (3), dudit moteur de démarreur (4), dudit alternateur (5) et dudit régulateur (9) d'une manière intégrée, comportant des moyens destinés à mesurer des paramètres caractéristiques de chaque dispositif parmi ladite au moins une batterie (3), ledit moteur de démarreur (4), ledit alternateur (5) et ledit régulateur (9) au cours de leur fonctionnement, lorsqu'ils sont installés sur le véhicule, et à comparer les paramètres caractéristiques mesurés à des paramètres caractéristiques théoriques calculés sur la base de l'état de fonctionnement correct d'au moins un autre dispositif parmi ladite au moins une batterie (3), ledit moteur de démarreur (4), ledit alternateur (5) et ledit régulateur (9).

22. Dispositif selon la revendication 21, caractérisé par le fait qu'il comprend des moyens (12, 15) destinés à mesurer la tension, le courant et la température de la batterie, des moyens (18) destinés à détecter la vitesse de rotation du moteur et des moyens (12) destinés à établir une corrélation entre les valeurs de courant et de tension mesurées et la vitesse de rotation et la température détectées et à déterminer les caractéristiques de fonctionnement réelles.

Fig. 1

CONNECTION — 30

ENTER COMPONENT DATA — 31

MEASURE RI — 32

MEASURE T — 33

CALCULATE $RI_N$ — 34

MEASURE V — 35

CALCULATE $RI_t$ — 36

37

EFFICIENT BATTERIES

EVALUATION

WORN BATTERIES
DISCHARGED BATTERIES

DOUBT

40

TEST STARTING DEVICE

40

TEST STARTING DEVICE

38

MESSAGE "RECHARGE REQUIRED"

41

TEST ALTERNATOR/ REGULATOR

TEST ALTERNATOR/ REGULATOR — 41

MESSAGE "REPLACEMENT REQUIRED"

TEST BATTERIES / III

TEST BATTERIES / II — 42

43

TEST BATTERIES / III — 43

39

END

END

Fig. 2

15

Fig. 3

Fig. 4

Fig.5

Fig.6

Fig.7

Fig.8

Fig.9

Fig.10

Fig.11

20

Fig.12

Fig.13

Fig.14

21